Europäisches Patentamt

European Patent Office

Office européen des brevets

(19)

(11) Veröffentlichungsnummer: **0 237 894**
**A2**

(12) **EUROPÄISCHE PATENTANMELDUNG**

(21) Anmeldenummer: 87103282.7

(22) Anmeldetag: 07.03.87

(51) Int. Cl.⁴: **G06F 13/40**

(30) Priorität: 19.03.86 DE 3609170

(43) Veröffentlichungstag der Anmeldung:
23.09.87 Patentblatt 87/39

(84) Benannte Vertragsstaaten:
AT BE CH DE FR GB LI LU NL SE

(71) Anmelder: Chemie und Filter GmbH
Im Schuhmachergewann 7-11 Postfach
101760
D-6900 Heidelberg(DE)

(72) Erfinder: Heinecke, Wolfgang, Dr.
Haselnussweg 36
D-6940 Weinheim(DE)

(74) Vertreter: Knoblauch, Ulrich, Dr.-Ing.
Kühhornshofweg 10
D-6000 Frankfurt am Main 1(DE)

(54) **Elektronisches Gerät mit aufeinandergestapelten Hauptmodulen.**

(57) Ein elektronisches Gerät, wie Mikrocomputer, besitzt aufeinandergestapelte Hauptmodule mit einer Gruppe von Anschlüssen, die auf der einen Modulseite mit Steckerstiften und auf der anderen Modulseite mit Steckerbuchsen versehen sind. Es gibt mindestens ein Zwischenmodul (2) mit zwei Anschlußgruppen (A2, A3), die beide der Hauptmodul-Anschlußgruppe entsprechen, aber gegenseitig versetzt sind. Die beiden benachbarten Hauptmodule sind in gleicher Weise gegeneinander versetzt und mit unterschiedlichen Zwischenmodul-Anschlußgruppen (A2, A3) durch Stecken verbunden. Auf diese Weise lassen sich Stapel mit Modulen errichten, deren Busabschnitte nicht unmittelbar miteinander verbunden sind.

Fig. 4

EP 0 237 894 A2

## Elektronisches Gerät mit aufeinandergestapelten Hauptmodulen

Die Erfindung bezieht sich auf ein elektronisches Gerät, wie Mikrocomputer, mit aufeinandergestapelten Hauptmodulen, die zur elektrischen Verbindung mit einem Nachbarmodul eine Anschlußgruppe aufweisen, die auf der einen Modulseite mit Steckerstiften und auf der anderen Modulseite mit Steckerbüchsen versehen ist.

Module für solche Geräte werden beispielsweise von der National Semiconductor Corporation unter der Familien-Bezeichnung MA2000 vertrieben. Es gibt Mikrocomputer-Module, Speicher-Module, Analog-Module usw. Diese enthalten jeweils eine mit integrierten Schaltkreisen und sonstigen Bauelementen bestückte Platine. Die elektrische und mechanische Verbindung der Module untereinander erfolgt mit Hilfe der steckbaren Anschlüsse. Diese sind in zwei Reihen nahe den Längsrändern der rechteckigen Module angeordnet. Peripherieanschlüsse, die seitlich vorstehen, können an den Schmalseiten der Module vorgesehen sein.

Auf diese Weise lassen sich aus einer begrenzten Zahl von Modulen sehr unterschiedliche elektrische Geräte in kompakter Form zusammenbauen. Die miteinander verbundenen Anschlüsse benachbarter Module bilden einen durchgehenden Bus, der Daten-, Steuer-, Speise-und andere Leitungen aufweisen kann. Es ist daher kein gesonderter Bus erforderlich.

Diese Konstruktion eignet sich aber nur für Geräte, deren Module an den gleichen Bus angeschlossen sind.

Der Erfindung liegt demgegenüber die Aufgabe zugrunde, ein aus gestapelten Modulen gebildetes elektronisches Gerät anzugeben, bei dem einzelnen Stapelteilen zugeordnete Busabschnitte voneinander getrennt oder über Zwischenglieder miteinander verbunden sind.

Diese Aufgabe wird erfindungsgemäß dadurch gelöst, daß mindestens ein Zwischenmodul mit zwei Anschlußgruppen versehen ist, die beide der Hauptmodul-Anschlußgruppe entsprechen, aber gegeneinander versetzt sind, und daß die beiden benachbarten Hauptmodule in gleicher Weise gegeneinander versetzt und mit unterschiedlichen Zwischenmodul-Anschlußgruppen durch Stecken verbunden sind.

Das Zwischenmodul erlaubt es, in einem Stapel zwei Stapelteile vorzusehen, die durch Stecken miteinander verbunden sind, deren Bus-Abschnitte aber nicht unmittelbar aneinanderschließen. Es ist lediglich erforderlich, die Hauptmodul-Anschlußgruppen der angrenzenden Hauptmodule unterschiedlichen Zwischenmodul-Anschlußgruppen zuzuordnen. Im Zwischmodul können einzelne Busleitungen, beispielsweise die Speiseleitungen der beiden Anschlußgruppen, miteinander verbunden und andere Leitungen völlig voneinander getrennt sein. Man kann aber auch zugehörige Anschlüsse beider Anschlußgruppen über auf dem Zwischenmodul montierte, Zwischenglieder miteinander verbinden.

Besonders günstig ist es, daß die Versetzung der Hauptmodule eine Drehversetzung ist, die Zwischenmodul-Anschlußgruppen außerhalb der Drehachse angeordnet sind und der Versetzungs-Drehwinkel so gewählt ist, daß die Anschlüsse der beiden Zwischenmodul-Anschlußgruppen unterschiedliche Flächen des Zwischenmoduls belegen. Durch die Drehversetzung kann man den Schwerpunkt der einzelnen Module etwa in der Stapelmitte belassen, so daß sich ein sehr stabiler Stapel ergibt.

Insbesondere hat der Umfang der Module eine solche Form, daß er nach Drehung um den Versetzungs-Drehwinkel mit sich selbst zur Deckung kommt. Daher ergibt sich ein Stapel mit weitgehend gleichmäßiger äußerer Kontur auch dann, wenn gegeneinander versetzte Stapelteile benötigt werden.

Wenn die Module Befestigungslöcher aufweisen, sollten diese so angeordnet sein, daß sie nach Drehung um den Versetzungs-Drehwinkel mit sich selbst zur Deckung kommen. Auch die zusätzlichen Befestigungslöcher können dann mit durchgehenden Schrauben u.dgl. versehen werden.

Bei einer bevorzugten Ausführungsform beträgt der Versetzungs-Drehwinkel 90°, und die Module haben einen quadratischen Umfang. Dies ergibt einen formschönen Stapel. Er kann auch eine verhältnismäßig große Höhe erhalten, ohne daß seine Stabilität leidet.

Mit besonderem Vorteil besteht jede Anschlußgruppe aus zwei Anschlußleisten, die längs einander gegenüberliegender Randabschnitte der Module angeordnet sind, und allen vier Randabschnitten des Zwischenmoduls ist je eine Anschlußleiste der beiden Zwischenmodul-Anschlußgruppen benachbart. Dies erlaubt es, eine verhältnismäßig große Zahl von Anschlüssen, entsprechend einem Bus mit vielen Leitungen, vorzusehen.

Es gibt zahlreiche Möglichkeiten, das Zwischenmodul auszugestalten. Vorzugsweise ist das Zwischenmodul ein Signalverstärker-Modul, das über die eine Anschlußgruppe zugeführte Signale verstärkt und über die andere Anschlußgruppe abgibt und/oder umgekehrt. Auf diese Weise können über Bus-Leitungen erführte Signale verstärkt werden. Ein solcher Bus-Verstärker empfiehlt sich, wenn ein System viele Module enthält und die Signalquellen nicht überlastet werden sollen.

Eine andere empfehlenswerte Möglichkeit besteht darin, daß das Zwischenmodul ein Separator-Modul ist, das über die eine Anschlußgruppe zugeführte Signale speichert und bei Abruf über die andere Anschlußgruppe abgibt und/oder umgekehrt. Solche Bus-Separatoren können verwendet werden, wenn mehrere Mikroprozessoren im Gesamtsystem simultan und unter einem teilweisen Datenaustausch aktiv sein sollen. Solche Multi-Prozessorsysteme sind beispielsweise erforderlich, wenn ein Handhabungsgerät (Roboter) gleichzeitig in mehreren Bewegungsrichtungen gesteuert werden muß.

Die Erfindung wird nachstehend anhand eines in der Zeichnung dargestellten, bevorzugten Ausführungsbeispiels näher erläutert. Es zeigen:

Fig. 1 eine schematische Vorderansicht eines elektronischen Geräts gemäß der Erfindung,

Fig. 2 einen Schnitt durch eine Anschlußleiste eines der Module,

Fig. 3 eine Draufsicht auf einen Hauptmodul,

Fig. 4 eine Draufsicht auf einen Zwischenmodul und

Fig. 5 einen Teil des Geräts in einem Blockschaltbild.

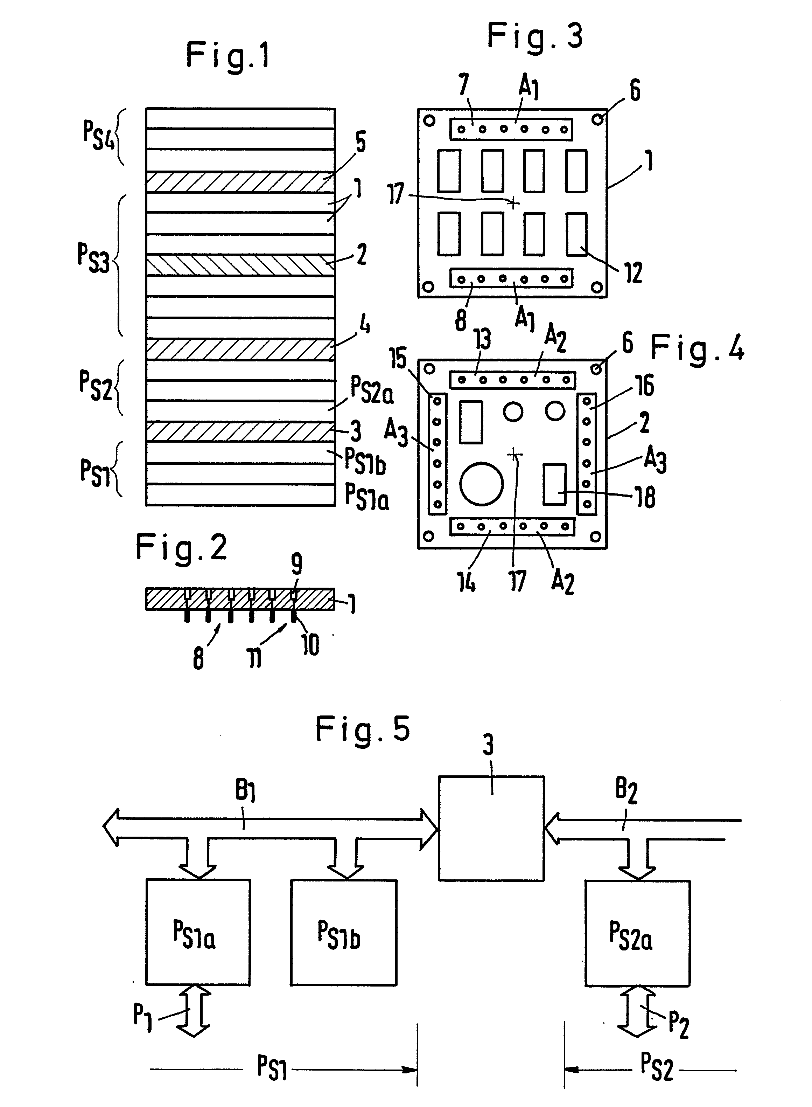

Fig. 1 zeigt ein elektronisches Gerät, das aus einer größeren Zahl von Hauptmodulen 1, einem Verstärker-Zwischenmodul 2 und drei Separator-Zwischenmodulen 3, 4 und 5 übereinandergestapelt ist. Die drei untersten Hauptmodule bilden ein autarkes Prozessorsystem PS1, das durch das Separator-Zwischenmodul 3 von dem ebenfalls aus drei Hauptmodulen bestehenden autarken Prozessorsystem PS2 getrennt ist. Es folgt das Separator-Zwischenmodul 4 und ein autarkes Prozessorsystem PS3, das aus sechs Hauptmodulen und dem Verstärker-Zwischenmodul 2 besteht. Darüber befindet sich das Separator-Zwischenmodul 5 und ein weiteres autarkes Prozessorsystem PS4 mit drei Hauptmodulen. Das Prozessorsystem PS1 besteht beispielsweise aus einem CPU-Mudul, einem Speicher-Modul und einem Analog-Modul mit Ein-und Ausgängen für Peripheriewerte. In üblicher Weise besitzen die Module je eine mit elektronischen Bauteilen bestückte Platine. Sie erfüllen verschiedene Funktionen der Prozeßsteuerung, Regelung und Datenverarbeitung.

Wie die Fig. 2 bis 4 zeigen, haben die Hauptmodule 1 und auch die Zwischenmodule 2 einen quadratischen Umfang und besitzen in jeder Ecke ein Befestigungsloch 6. Beim Hauptmodul 1 gibt es zwei Anschlußleisten 7 und 8, die sich längs den gegenüberliegenden Rändern erstrecken. Sie bilden zusammen eine Anschlußgruppe A1. An der Oberseite weisen sie Steckerbuchsen 9 und an der Unterseite Steckerstifte 10 auf, die paarweise miteinander verbunden sind und einen Anschluß 11 bilden. Diese Anschlüsse 11 stellen die diesem Modul zugeordneten Leiterabschnitte eines Prozessorbus dar, der beispielsweise Daten-, Adreß-, Steuer-, Speise-und sonstige Leitungen aufweist.

Die Zahl der Anschlüsse 11 ist in der Praxis erheblich größer als in Fig. 3 dargestellt und beträgt beispielsweise 48. Die Anschlüsse 11 sind, soweit erforderlich, mit den auf der Platine angeordneten Bauelementen 12 sinnrichtig verbunden.

Die Zwischenplatine 2 weist insgesamt vier Anschlußleisten 13, 14, 15 und 16 auf. Die Anschlußleisten 13 und 14 bilden zusammen eine Anschlußgruppe A2 und die Anschlußleisten 15 und 16 eine zweite Anschlußgruppe A3. Die Steckerstifte 10 der Anschlußgruppe A1 des Hauptmoduls 1 können in die Steckerbuchsen 9 der Anschlußgruppe A2 des Zwischenmoduls oder -nach einer Drehversetzung um 90° bezogen auf eine Drehachse 17 in die Steckerbuchsen der Anschlußgruppe A3 gesteckt werden. Die beiden Anschlußgruppen A2 und A3 entsprechen daher der Anschlußgruppe A1 und sind lediglich um 90° durch Drehung versetzt.

Bei dem Gerät in Fig. 1 haben daher die Module der Prozessorsysteme PS1 und PS4 sowie die drei unteren Hauptmodule des Prozessorsystems PS3 die gleiche Ausrichtung wie in Fig. 3, während die Hauptmodule des Prozessorsystems PS2 und die oberen drei Module des Prozessorsystems PS3 demgegenüber um 90° drehversetzt sind. Dies hat zur Folge, daß die Busabschnitte des Prozessorsystems PS2 nicht mehr mit den Busabschnitten des Prozessorsystems PS1 verbunden sind, sondern daß diese Verbindung nur noch über die auf den Separator-Zwischenmodul vorgesehenen Pfade und Schaltglieder erfolgen kann. Ähnliches gilt für die darüber befindlichen, gegeneinander versetzen Module.

In Fig. 4 sind die auf der dortigen Platine vorgesehenen Schaltglieder 18 so ausgelegt, daß sich zwischen zumindest einigen der Anschlüsse der Anschlußgruppen A2 und A3 eine Verstärkerschaltung ergibt.

In Fig. 5 ist schematisch andeutet, daß jeweils ein Modul PS1a und PS2a Peripherie-Anschlüsse PS1 bzw. PS2 aufweist, die als Eingang oder Ausgang für Daten oder Steuersignale benutzt werden können. Die Anschlüsse 11 der zugehörigen Module bilden einen Prozessorbus B1 für das Prozessorsystem PS1 und einen Prozessorbus B2 für das Prozessorsystem PS2. Der Prozessorbus B1 ist über das Separator-Zwischenmodul 3 mit dem Prozessorbus B2 verbunden. Beispielsweise besitzt das Zwischenmodul 3 einen Speicher, dem Signale über die Anschlußgruppe A2 zugeführt werden können. Von diesem Speicher kann sie das folgende Prozessorsystem PS2 über die Anschlußgruppe A3 abrufen. Diese Arbeitsweise entspricht dem bekannten Mailbox-System.

Von der veranschaulichten Ausführungsform kann in vielfacher Hinsicht abgewichen werden, ohne den Grundgedankan der Erfindung zu verlassen. Beispielsweise können die Anschlüsse 11 jeweils an einem Rand des Moduls konzentriert sein. In diesem Fall kann statt eines Versetzungsdrehwinkels von 90° auch ein solcher von 180° benutzt werden. Der Umfang der Platinen kann auch kreisrund sein. Insgesamt lassen sich neuartige elektronische Geräte in Stapelform angeben. Besonders interessant ist es, daß man mehrere gleichzeitig arbeitende Prozessorsysteme in einem gemeinsamen Stapel anordnen kann. Die Befestigungslöcher 6 ermöglichen es, den Stapel mechanisch zu versteifen und ihn in einem Gehäuse mittels Abstandsbolzen, Gewindestangen oder anderer mechanischer Elemente zu befestigen.

**Ansprüche**

1. Elektronisches Gerät, wie Mikrocomputer, mit aufeinandergestapelten Hauptmodulen, die zur elektrischen Verbindung mit einem Nachbarmodul eine Anschlußgruppe aufweisen, die auf der einen Modulseite mit Steckerstiften und auf der anderen Modulseite mit Steckerbuchsen versehen ist, dadurch gekennzeichnet, daß mindestens ein Zwischenmodul (2 bis 5) mit zwei Anschlußgruppen - (A2, A3) versehen ist, die beide der Hauptmodul-Anschlußgruppe (A1) entsprechen, aber gegeneinander versetzt sind, und daß die beiden benachbarten Hauptmodule (1) in gleicher Weise gegeneinander versetzt und mit unterschiedlichen Zwischenmodul-Anschlußgruppen durch Stecken verbunden sind.

2. Elektronisches Gerät nach Anspruch 1, dadurch gekennzeichnet, daß die Versetzung der Hauptmodule (1) eine Drehversetzung ist, die Zwischenmodul-Anschlußgruppen (A2, A3) außerhalb der Drehachse (17) angeordnet sind und der Versetzungs-Drehwinkel so gewählt ist, daß die Anschlüsse (11) der beiden Zwischenmodul-Anschlußgruppen unterschiedliche Flächen des Zwischenmoduls (2 bis 5) belegen.

3. Elektronisches Gerät nach Anspruch 2, dadurch gekennzeichnet, daß der Umfang der Module (1 bis 5) eine solche Form hat, daß er nach Drehung um den Versetzungs-Drehwinkel mit sich selbst zur Deckung kommt.

4. Elektronisches Gerät nach Anspruch 2 oder 3, dadurch gekennzeichnet, daß die Module (1 bis 5) Befestigungslöcher (6) aufweisen, die so angeordnet sind, daß sie nach Drehung um den Versetzungs-Drehwinkel mit sich selbst zur Deckung kommen.

5. Elektronisches Gerät nach einem der Ansprüche 2 bis 4, dadurch gekennzeichnet, daß der Versetzungs-Drehwinkel 90° beträgt und die Module (1 bis 5) einen quadratischen Umfang haben.

6. Elektronisches Gerät nach Anspruch 5, dadurch gekennzeichnet, daß jede Anschlußgruppe (A1, A2, A3) aus zwei Anschlußleisten (7, 8; 13, 14; 15, 16) besteht, die längs einander gegenüberliegender Randabschnitte der Module (1 bis 6) angeordnet sind, und daß allen vier Randabschnitten des Zwischenmoduls (2 bis 5) je eine Anschlußleiste der beiden Zwischenmodul-Anschlußgruppen benachbart ist.

7. Elektronisches Gerät nach einem der Ansprüche 1 bis 6, dadurch gekennzeichnet, daß das Zwischenmodul (2) ein Signalverstärker-Modul ist, das über die eine Anschlußgruppe (A2) zugeführte Signale verstärkt und über die andere Anschlußgruppe (A3) abgibt und/ oder umgekehrt.

8. Elektronisches Gerät nach einem der Ansprüche 1 bis 7, dadurch gekennzeichnet, daß das Zwischenmodul (3 bis 5) ein Separator-Modul ist, das über die eine Anschlußgruppe (A2) zugeführte Signale speichert und bei Abruf über die andere Anschlußgruppe (A3) abgibt und/oder umgekehrt.

Fig.1

Fig. 3

Fig.2

Fig. 4

Fig. 5